Europäisches Patentamt

European Patent Office

Office européen des brevets

(11) Veröffentlichungsnummer: **0 217 065 B1**

(12) **EUROPÄISCHE PATENTSCHRIFT**

(45) Veröffentlichungstag der Patentschrift: **18.09.91**

(51) Int. Cl.⁵: **G05F  3/20**

(21) Anmeldenummer: **86110757.1**

(22) Anmeldetag: **04.08.86**

(54) Integrierte Schaltung in komplementärer Schaltungstechnik mit einem Substratvorspannungs-Generator.

(30) Priorität: **26.08.85 DE 3530427**

(43) Veröffentlichungstag der Anmeldung:
**08.04.87 Patentblatt  87/15**

(45) Bekanntmachung des Hinweises auf die
Patenterteilung:
**18.09.91 Patentblatt  91/38**

(84) Benannte Vertragsstaaten:
**AT DE FR GB IT NL**

(56) Entgegenhaltungen:
**EP-A- 0 036 494**
**WO-A-84/03185**
**US-A- 4 109 161**

**IBM TECHNICAL DISCLOSURE BULLETIN,**
**Band 24, Nr. 11B, April 1982, Seiten**
**6077,6078, New York, US; F. DELAPORTE et**
**al.: "Substrate connection by analog swit-**
**ching to most negative power supply"**

(73) Patentinhaber: **Siemens Aktiengesellschaft**
**Wittelsbacherplatz 2**
**W-8000 München 2(DE)**

(72) Erfinder: **Takàcs, Dezsö, Dipl.-Phys.**
**Annette-Kolb-Anger 7**
**W-8000 München 83(DE)**
Erfinder: **Winnerl, Josef, Dr.-Ing.**
**Schubert Strasse 2**
**W-8300 Landshut(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung bezieht sich auf eine integrierte Schaltung in komplementärer Schaltungstechnik mit einem Substratvorspannungs-Generator nach den ersten Teilen der Patentansprüche 1 und 5.

Bei Schaltungen dieser Art liegt das Halbleitersubstrat nicht auf dem Massepotential $V_{SS}$ der Schaltung, sondern auf einer Substratvorspannung $V_{BB}$, die mittels eines Substratvorspannungs-Generators erzeugt wird. Bei einem Halbleitersubstrat aus p-leitendem Material, das mit einer eingefügten n-leitenden wannenförmigen Halbleiterzone versehen ist, handelt es sich dabei um eine negative Substratvorspannung von etwa - 2 bis - 3 Volt. Die Source-Gebiete von Feldeffekttransistoren, die außerhalb der wannenförmigen Halbleiterzone auf dem Halbleitersubstrat vorgesehen sind, sind hierbei auf das Massepotential $V_{SS}$ gelegt.

Im Moment des Einschaltens der positiven Versorgungsspannung $V_{DD}$ befindet sich das betrachtete p-leitende Halbleitersubstrat zunächst in einem Zustand des "floating", in dem es von äußeren Potentialen freigeschaltet ist. Dabei kann es über die Sperrschichtkapazitäten, die einerseits zwischen der wannenförmigen Halbleiterzone und dem Substrat und andererseits zwischen den mit dem Massepotential belegten Sourcegebieten und dem Substrat vorhanden sind, vorübergehend auf eine positive Vorspannung aufgeladen werden, die erst beim Wirksamwerden des Substratvorspannungs-Generators wieder abgebaut und durch die sich am Ausgang desselben allmählich aufbauende negative Substratvorspannung ersetzt wird. Aber auch im Betrieb der integrierten Schaltung können größere Ströme, die vom Halbleitersubstrat über den Substratvorspannungs-Generator zu einem auf Massepotential liegenden Anschluß des letzteren abgeleitet werden, durch den Spannungsabfall am Innenwiderstand des Substratvorspannungs-Generators zu einer positiven Vorspannung des Halbleitersubstrates führen. Positive Vorspannungen stellen aber ein hohes Sicherheitsrisiko für die integrierte Schaltung dar, da ein "latch-up"-Effekt ausgelöst werden kann, der im allgemeinen den Ausfall der integrierten Schaltung bedeutet.

Zum Verständnis des "latch-up"-Effekts kann man davon ausgehen, daß zwischen einem Anschluß eines in der wannenförmigen Halbleiterzone liegenden Feldeffekttransistors des ersten Kanaltyps und einem Anschluß eines außerhalb dieser Zone auf dem Halbleitersubstrat plazierten Feldeffekttransistors des zweiten Kanaltyps im allgemeinen vier aufeinanderfolgende Halbleiterschichten alternierender Leitfähigkeitstypen vorhanden sind, wobei das eine Anschlußgebiet des erstgenannten Transistors die erste Halbleiterschicht, die wannenförmige Halbleiterzone die zweite, das Halbleitersubstrat die dritte und das eine Anschlußgebiet des letzteren Transistors die vierte Halbleiterschicht bilden. Bei einer positiven Vorspannung des Halbleitersubstrats kann der pn-Übergang zwischen der dritten und vierten Halbleiterschicht so weit in Durchlaßrichtung vorgespannt werden, daß zwischen den genannten Transistoranschlüssen ein Strompfad entsteht, der auf eine parasitäre Thyristorwirkung innerhalb dieser Vierschichtenstruktur zurückzuführen ist. Der Strompfad bleibt dann auch nach einem Abbau der positiven Substratvorspannung bestehen und kann die integrierte Schaltung thermisch überlasten.

Der Erfindung liegt die Aufgabe zugrunde, eine Schaltung der eingangs genannten Art anzugeben, bei der das Auftreten von "latch-up"-Effekten weitgehend vermieden wird. Das wird erfindungsgemäß durch eine Ausbildung der Schaltung nach den kennzeichnenden Teilen der Patentansprüche 1 oder 5 erreicht.

Die Patentansprüche 2 bis 4 und 6 bis 10 sind auf bevorzugte Ausgestaltungen und Weiterbildungen der Erfindung gerichtet. Der Patentanspruch 11 betrifft eine bevorzugte Anwendung der Erfindung.

Der mit der Erfindung erzielbare Vorteil liegt insbesondere darin, daß eine am Halbleitersubstrat liegende Vorspannung unerwünschter Polarität, die einen "latch-up"-Effekt auslösen kann, mit einfachen Mitteln auf einen Wert begrenzt wird, der diese Gefahr ausschließt.

Die Erfindung wird nachfolgend anhand eines in der Zeichnung dargestellten bevorzugten Ausführungsbeispiels näher erläutert.

Dabei ist eine erfindungsgemäße integrierte Schaltung dargestellt, die auf einem Halbleitersubstrat 1 aus dotiertem Halbleitermaterial, zum Beispiel p-leitendem Silizium, aufgebaut ist. Das Substrat 1 weist eine n-leitende, wannenförmige Halbleiterzone 2 auf, die sich bis zur Grenzfläche 1a des Substrats 1 hin erstreckt. Außerhalb der Halbleiterzone 2 sind in das Substrat 1 $n^+$-dotierte Halbleitergebiete 3 und 4 eingefügt, die das Source- und Drain-Gebiet eines n-Kanal-Feldeffekttransistors T1 bilden. Der zwischen 3 und 4 liegende Kanalbereich wird von einem Gate 5 überdeckt, das mit einem Anschluß 6 versehen ist und durch eine dünne elektrisch isolierende Schicht 7, zum Beispiel aus $SiO_2$, von der Grenzfläche 1a getrennt ist. Das Source-Gebiet 3 ist mit einem Anschluß 8 verbunden, der auf einem Massepotential $V_{SS}$ liegt. Weiterhin sind in die Halbleiterzone 2 $p^+$-dotierte Gebiete 9 und 10 eingefügt, welche das Source- und das Drain-Gebiet eines p-Kanal-Feldeffekttransistors T2 darstellen. Der zwischen den Gebieten 9 und 10 liegende Kanalbereich wird von einem Gate 11 überdeckt, das mit einem Anschluß 12 versehen ist und durch eine dünne elektrisch isolierende Schicht 13, zum Beispiel aus $SiO_2$, von der Grenzfläche 1a getrennt ist. Das Source-Gebiet 9 von T2 ist mit einem Anschluß 14 verbunden, der mit einem Versorgungspotential $V_{DD}$ beschaltet ist. Über ein $n^+$-dotiertes Kontaktgebiet 15, das mit dem Anschluß 14 in Verbindung steht, liegt die Halbleiterzone 2 auf der Versorgungsspannung $V_{DD}$.

Weiterhin ist ein Substratvorspannungs-Generator 16 vorgesehen, der eine negative Substratvorspannung von zum Beispiel - 2 bis - 3 Volt erzeugt. Der Ausgang 17 des Substratvorspannungs-Generators ist mit einem $p^+$-dotiertem Kontaktgebiet 18 verbunden, das in das Halbleitersubstrat 1 eingefügt ist. Damit befindet sich das Halbleitersubstrat 1 auf der durch 16 erzeugten negativen Substratvorspannung, während sich die Source-Gebiete, zum Beispiel 3, der im Halbleitersubstrat 1 befindlichen Transistoren, zum Beispiel T1, auf Massepotential $V_{SS}$ befinden. Hierdurch wird unter anderem erreicht, daß die Sperrschichtkapazitäten der Source-Gebiete der im Substrat 1 angeordneten Transistoren verkleinert werden.

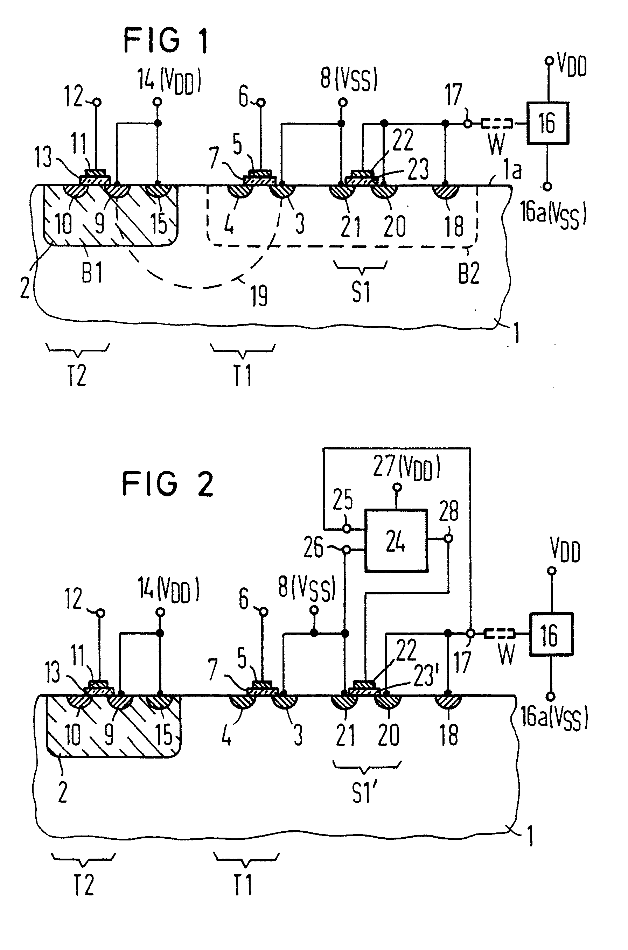

Zur Vermeidung eines "latch-up"-Effekts, der innerhalb der entlang der gestrichelten Linie 19 zwischen den Anschlüssen 8 und 14 liegenden Vierschichtenstruktur 3, 1, 2 und 9 auftreten könnte, ist der Ausgang 17 des Substratvorspannungs-Generators 16 über einen elektronischen Schalter S1 mit einem Schaltungspunkt verbunden, der sich auf Massepotential befindet. Beim dargestellten Ausführungsbeispiel handelt es sich bei diesem Schaltungspunkt um den Anschluß 8. Im einzelnen ist der Ausgang 17 bei der Anordnung nach Figur 1 mit einem $n^+$-dotierten Halbleitergebiet 20 verbunden, das in das Halbleitersubstrat 1 eingefügt ist. Ein weiteres $n^+$-dotiertes, in das Halbleitersubstrat 1 eingefügtes Halbleitergebiet 21 ist mit dem auf Massepotential liegenden Schaltungspunkt, das heißt insbesondere mit dem Anschluß 8, verbunden. Der zwischen den Gebieten 20 und 21 liegende Bereich des Halbleitersubstrats 1 ist von einem Gate 22 überdeckt, das durch eine dünne elektrisch isolierende Schicht 23, zum Beispiel aus $SiO_2$, von der Grenzfläche 1a getrennt ist. Die Gebiete 20 und 21 bilden zusammen mit den Teilen 22 und 23 einen n-Kanal-Feldeffekt-Schalttransistor der den elektronischen Schalter S1 darstellt. Die Ansteuerung von S1 erfolgt über den Ausgang 17 des Substratvorspannungs-Generators 16. Zu diesem Zwecke ist in Figur 1 das Gate 22 direkt mit dem Ausgang 17 verbunden.

Der Schalttransistor 20 bis 23 soll in Figur 1 eine niedrige Einsatzspannung haben, die kleiner ist als die Durchlaßspannung des pn-Übergangs zwischen 1 und 3. Das ist in herkömmlicher Weise zum Beispiel dadurch zu erreichen, daß der zwischen den Gebieten 20 und 21 liegende Bereich des Substrats 1 außer der Grunddotierung, die zum

Beispiel $10^{15}$ $cm^{-3}$ beträgt, keine zusätzliche Dotierung aufweist, während die Kanalbereiche der übrigen Feldeffekttransistoren, zum Beispiel T1, in der Nähe der Grenzfläche 1a mit einer zusätzlichen, die Grunddotierung verstärkenden Dotierung versehen sind, die zweckmäßigerweise im Wege einer Implantation mit einer Dosis von etwa $10^{12}$ $cm^{-2}$ eingebracht wird. Sind in der verwendeten Herstellungstechnik zwei verschiedene Isolierschichtdicken verfügbar, so wird für 23 zweckmäßigerweise die kleinere verwendet, die zum Beispiel 15 nm beträgt, während für die Schicht 7 und 13 eine Dicke von etwa 20 - 25 nm gewählt wird.

Liegt das Halbleitersubstrat 1 auf einer positiven Vor-spannung, so ist auch das Gate 22 entsprechend positiv vorgespannt, was beim Überschreiten der niedrigen Einsatzspannung dazu führt, daß der Schalttransistor 20 bis 23 leitet. Damit wird dann die Spannung an 17 auf den Wert der niedrigen Einsatzspannung begrenzt. Diese Klemmwirkung tritt zum Beispiel dann ein, wenn beim Anschalten der Versorgungsspannung $V_{DD}$ das Halbleitersubstrat 1 durch die kapazitive Spannungsteilung zwischen den Anschlüssen 14 und 8 solange auf eine positive Vorspannung angehoben wird, als der Generator 16 noch nicht die volle negative Vorspannung liefert. Erst wenn sich anschließend die negative Vorspannung am Ausgang 17 aufzubauen beginnt, sperrt der Schalttransistor 20 bis 23 beim Unterschreiten der niedrigen Einsatzspannung, so daß die beschriebene Klemmwirkung unterbunden wird. Ergeben sich im Betrieb große Ströme, die über das Halbleitersubstrat 1 und die Teile 18, 17 und 16 zum Anschluß 16a, der auf Massepotential $V_{SS}$ liegt, abfließen, so kann am Innenwiderstand W von 16 ein solcher Spannungsabfall entstehen, daß der Ausgang 17 und damit das Halbleitersubstrat 1 zumindest vorübergehend auf eine positive Vorspannung gelangt. Auch in diesem Fall leitet der Schalttransistor 20 bis 23 beim Überschreiten der niedrigen Einsatzspannung, so daß die Spannung an 17 wieder auf den Wert der niedrigen Einsatzspannung begrenzt wird. Diese Klemmwirkung wird unterbunden, sobald sich am Substrat 1 wieder eine negative Vorspannung einzustellen beginnt und dabei die niedrige Einsatzspannung unterschritten wird.

Der Substratvorspannungs-Generator 16 ist zweckmäßig auf dem Halbleitersubstrat 1 mit aufintegriert.

In Figur 2 ist ein zweites Ausführungsbeispiel der Erfindung dargestellt, das sich von Figur 1 durch eine modifizierte Ansteuerung des elektronischen Schalters S1 unterscheidet. Im einzelnen ist ein Komparator 24 mit zwei Eingängen 25 und 26 vorgesehen, wobei 25 mit dem Ausgang 17 des Substratvorspannungs-Generators 16 beschaltet ist, während 26 mit dem auf Massepotential liegenden Anschluß 8 verbunden ist. Der Komparator 24 ist über einen Anschluß 27 mit der Versorgungsspannung $V_{DD}$ beschaltet. Ein Ausgang 28 des Komparators ist mit dem Gate 22 des elektronischen Schalters S1 verbunden. Die isolierende Schicht unterhalb von 22 ist hierbei mit 23' bezeichnet.

Der Komparator 24 vergleicht die Spannung am Ausgang 17 des Substratvorspannungs-Generators 16 mit dem Massepotential $V_{SS}$. Liegt am Ausgang 17 und damit am Halbleitersubstrat 1 eine positive Spannung, die eine Schaltschwelle des Komparators 24 übersteigt, so wird über den Ausgang 28 des Komparators eine positive Spannung abgegeben, die den n-Kanal-Feldeffekttransistor 20 bis 23' leitend schaltet. Damit wird dann die Spannung am Ausgang 17 auf diese Schaltschwelle begrenzt. Wie bereits erwähnt, kann das beim Anschalten der Versorgungsspannung $V_{DD}$ der Fall sein, oder dann, wenn im Betrieb große Ströme über die Teile 1, 18, 17 und 16 nach 16a fließen. Baut sich nach dem Anschalten der Versorgungsspannung $V_{DD}$ oder beim Abklingen der genannten großen Ströme wieder die gewünschte negative Vorspannung am Ausgang 17 des Generators 16 auf, und liegt dementsprechend am Eingang 25 des Komparators 24 eine die Komparatorschwelle unterschreitende Spannung, so wird das Komparatorsignal am Ausgang 28 abgeschaltet, wobei der Transistor 20 bis 23' bzw. der elektronische Schalter S1 sperrt.

Das Ausführungsbeispiel nach Figur 2 unterscheidet sich weiterhin von dem nach Figur 1 dadurch, daß der elektronische Schalter S1 nicht mehr in Form eines Schalttransistors mit niedriger Einsatzspannung realisiert werden muß, da das Ausgangssignal des Komparators 24 so groß gewählt werden kann, daß auch eine Einsatzspannung, die der von T1 usw. entspricht, die Klemmwirkung gewährleistet.

Die Schicht 23' kann deswegen mit einer Dicke von etwa 20 bis 25 nm ausgeführt werden, die der Dicke der Schichten 7 und 13 gleichkommt. Auch bezüglich einer Zusatzimplantation im Kanalbereich braucht sich der Transistor 20 bis 23' nicht mehr von den anderen Transistoren, zum Beispiel T1, zu unterscheiden.

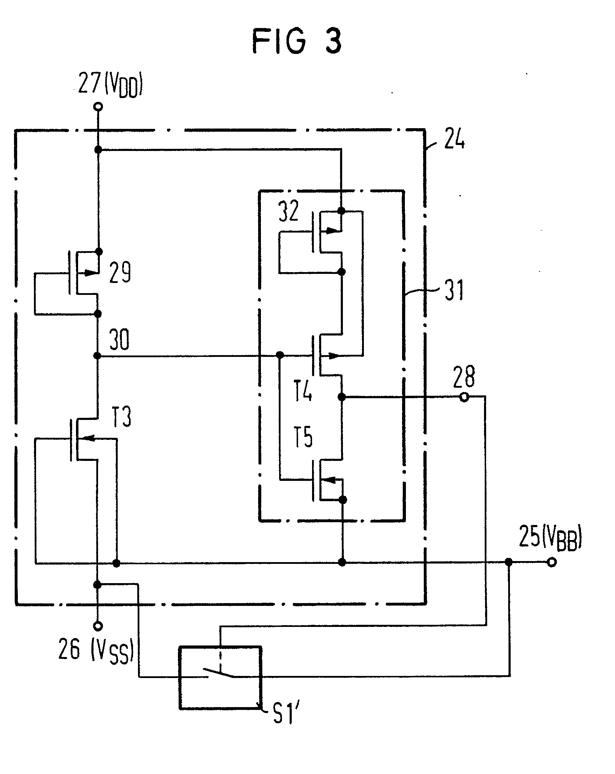

Figur 3 zeigt eine bevorzugte Ausgestaltung des Komparators 24. Dabei ist eine Serienschaltung eines n-Kanal-Feldeffekttransistors T3 und eines Lastelements 29 vorgesehen, das insbesondere durch einen p-Kanal-Feldeffekttransistor gebildet wird, dessen Gate mit seinem Drainanschluß verbunden ist. Der eine Anschluß der Serienschaltung, der gleichzeitig einen Anschluß von 29 bildet, entspricht dem mit $V_{DD}$ belegten Anschluß 27, während der andere Anschluß der Serienschaltung den mit Massepotential $V_{SS}$ beschalteten Eingang 26 des Komparators darstellt. Das Gate von T3 ist an den mit $V_{BB}$ beaufschlagten Eingang 25 des Komparators geführt. Der Verbindungspunkt 30 der Teile T3 und 29 ist über eine Verstärkerstufe 31 an den Ausgang 28 des Komparators geführt. Die als Inverter ausgebildete Verstärkerstufe 31 enthält eine Serienschaltung eines p-Kanal-Feldeffekttransistors T4 und einen n-Kanal-Feldeffekttransistor T5, deren Gates mit dem Verbindungspunkt 30 beschaltet sind. Der obere Anschluß von T4 ist über ein Lastelement 32 mit 27 verbunden, der untere Anschluß von T5 mit dem Eingang 25. Das Lastelement 32 ist zweckmäßig als p-Kanal-Feldeffekttransistor realisiert, dessen Gate mit seinem Drainanschluß verbunden ist. Der elektronische Schalter S1 ist entsprechend Figur 2 zwischen den Eingängen 25 und 26 des Komparators und damit zwischen den Schaltungspunkten 17 und 8 eingefügt.

Der Transistor T3 weist eine Einsatzspannung auf, die kleiner ist als die Durchlaßspannung des pn-Übergangs zwischen 1 und 3. Zu diesem Zweck wird er beispielsweise entsprechend dem Transistor 20 bis 23 ohne zusätzliche Kanalimplantation und mit einer nur eine Dicke von etwa 15 nm aufweisenden Gateisolierschicht realisiert.

Liegt am Eingang 25 eine Substratspannung an, die den Wert der niedrigen Einsatzspannung von T3 übersteigt, so leitet der Transistor T3. Dabei wird das Potential am Schaltungspunkt 30 abgesenkt, was über die Stufe 31 zu einer Anhebung des Potentials am Ausgang 28 führt. Hierdurch wird der als n-Kanal-Schalttransistor 20 bis 23' ausgebildete Schalter S1 leitend geschaltet, so daß die Klemmwirkung einsetzt. Sinkt die Substratspannung unter den Wert der Einsatzspannung von T3 ab, wird S1 gesperrt, so daß die Klemmwirkung unterbunden wird.

Der elektronische Schalter S1 bzw. S1' kann abweichend von den bisher beschriebenen Ausführungsformen auch in anderer Weise realisiert sein, zum Beispiel als bipolarer Transistor, der insbesondere als externes Schaltungselement ausgeführt und über Verbindungsleitungen an die Anschlüsse 8 und 17 geschaltet ist.

Die niedrige Einsatzspannung der Transistoren 20 bis 23 und T3 kann in an sich bekannter Weise auch durch eine entsprechend bemessene zusätzliche Dotierung ihrer Kanalbereiche erreicht werden, wozu jedoch ein zusätzlicher Maskenschritt bei der Herstellung der erfindungsgemäßen Schaltung erforderlich ist. Hierbei wird dann im allgemeinen die Gateisolierschicht dieser Transistoren entsprechend der der übrigen Transistoren bemessen.

Neben den oben behandelten Ausführungsformen umfaßt die Erfindung auch solche, bei denen n-leitende Substrate mit p-leitenden wannenförmigen Halbleiterzonen versehen sind. Dabei werden die Leitungstypen sämtlicher Halbleiterteile und die Polaritäten sämtlicher Spannungen durch die jeweils entgegengesetzten ersetzt.

Weiterhin werden auch solche Ausführungsformen von der Erfindung umfaßt, die sich aus Figur 1 durch folgende Abänderungen ergeben: Die Begrenzungslinie B1 zwischen den Teilen 1 und 2 fällt weg, wobei diese beiden Teile nunmehr als n-leitendes Substrat aufzufassen sind. Hiervon ausgehend wird dann in dieses n-leitende Substrat eine p-leitende wannenförmige Halbleiterzone eingefügt, die durch die gestrichelte Linie B2 gegen das n-leitende Substrat abgegrenzt ist und die Schaltungsteile T1, S1 und 18 enthält. Die Teile T2, T1, S1 und 18 sind dabei in derselben Weise beschaltet wie in Figur 1.

Eine bevorzugte Anwendung der Erfindung ergibt sich für Peripherieschaltungen von dynamischen Halbleiterspeichern großer Packungsdichte, die mit den Speicherzellen monolithisch integriert sind.

Bezugszeichenliste

| 1 | Halbleitersubstrat |
|---|---|
| 1a | Grenzfläche |
| 2 | Halbleiterzone |
| 3, 4 | Halbleitergebiete |
| 5 | Gate |
| 6 | Anschluß von 5 |
| 7 | Isolierschicht |
| 8 | Anschluß |
| 9, 10 | Halbleitergebiete |
| 11 | Gate |
| 12 | Anschluß von 11 |
| 13 | Isolierschicht |
| 14 | Anschluß |
| 15 | Kontaktgebiet |
| 16 | Substratvorspannungs-Generator |
| 17 | Ausgang von 16 |
| 18 | Kontaktgebiet |
| 19 | gestrichelte Linie |
| 20, 21 | Halbleitergebiete |
| 22 | Gate |
| 23 | Isolierschicht |
| 24 | Komparator |
| 25, 26 | Eingänge von 24 |
| 27 | Anschluß von 24 |
| 28 | Ausgang von 24 |
| 29 | Lastelement |
| 30 | Verbindungspunkt |
| 31 | Verstärkerstufe |
| 32 | Lastelement |
| T1 bis T5 | Feldeffekttransistoren |
| $V_{SS}$ | Massepotential |
| $V_{DD}$ | Versorgungspotential |
| S1 | elektronischer Schalter |
| B1 | Begrenzungslinie |
| B2 | Begrenzungslinie |

## Patentansprüche

1. Integrierte Schaltung in komplementärer Schaltungstechnik mit Feldeffekttransistoren (T1, T2) unterschiedlicher Kanaltypen, von denen wenigstens ein erster (T1) in einem dotierten Halbleitersubstrat (1) eines ersten Leitungstyps und wenigstens ein zweiter (T2) in einer im Halbleitersubstrat (1) vorgesehenen wannenförmigen Halbleiterzone (2) eines zweiten Leitungstyps angeordnet sind, wobei die Halbleiterzone mit einer Versorgungsspannung ($V_{DD}$) beschaltet ist, wobei ein Anschlußgebiet (3) wenigstens eines ersten im Halbleitersubstrat angeordneten Feldeffekttransistors (T1) mit einem Massepotential ($V_{SS}$) beaufschlagt ist und wobei das Halbleitersubstrat mit dem Ausgang (17) eines Substratvorspannungs-Generators (16) verbunden ist, dem das Massepotential und die Versorgungsspannung zugeführt werden und der den pn-Übergang zwischen dem auf Massepotential liegenden Anschlußgebiet des ersten Feldeffekttransistors und dem Halbleitersubstrat in Sperrrichtung vorspannt, **dadurch gekennzeichnet,** daß der Ausgang (17) des Substratvorspannungs-Generators (16) über einen elektronischen Schalter (S1) mit einem auf Massepotential liegenden Schaltungspunkt (8) verbunden ist, daß der elektronische Schalter über den Ausgang (17) des Substratvorspannungs-Generators (16) angesteuert wird und daß die Einsatzspannung des elektronischen Schalters (S1) kleiner ist als die Durchlaßspannung des pn-Übergangs zwischen dem auf Massepotential liegenden Anschlußgebiet (3) des ersten Feldeffekttransistors (T1) und dem Halbleitersubstrat (1).

2. Integrierte Schaltung nach Anspruch 1, **dadurch gekennzeichnet,** daß der Substratvorspannungs-Generator (16) auf dem Halbleitersubstrat (1) mit aufintegriert ist.

3. Integrierte Schaltung nach Anspruch 1 oder 2, **dadurch gekennzeichnet,** daß der Ausgang (17) des Substratvorspannungs-Generators (16) mit einem ersten in das Halbleitersubstrat eingefügten Halbleitergebiet (20) des zweiten Leitungstyps verbunden ist, daß in das Halbleitersubstrat ein zweites Halbleitergebiet (21) des zweiten Leitungstyps eingefügt ist, welches mit dem auf Massepotential liegenden Schaltungspunkt (8) verbunden ist, daß ein zwischen diesen beiden Halbleitergebieten (20, 21) liegender Bereich des Halbleitersubstrats (1) von einem durch eine dünne elektrisch isolierende Schicht (23) von der Grenzfläche (1a) des Halbleitersubstrats getrennten Gate (22) überdeckt ist, welches zusammen mit den beiden Halbleitergebieten einen Feldeffekt-Schalttransistor mit niedriger Einsatzspannung bildet, und daß dieser Feldeffekt-Schalttransistor, dessen Gate (22)mit dem Ausgang (17) des Substratvorspannungs-Generators (16) verbunden ist, den elektronischen Schalter (S1) bildet.

4. Integrierte Schaltung nach Anspruch 3, **dadurch gekennzeichnet,** daß die das Gate (22) von der Grenzfläche (1a) des Halbleitersubstrats trennende Isolierschicht (23) eine Dicke von etwa 15 nm aufweist.

5. Integrierte Schaltung in komplementärer Schaltungstechnik mit Feldeffekttransistoren (T1, T2) unterschiedlicher Kanaltypen, von denen wenigstens ein erster (T1) in einem dotierten Halbleitersubstrat (1) eines ersten Leitungstyps und wenigstens ein zweiter (T2) in einer im Halbleitersubstrat (1) vorgesehenen wannenförmigen Halbleiterzone (2) eines zweiten Leitungstyps angeordnet sind, wobei die Halbleiterzone mit einer Versorgungsspannung ($V_{DD}$) beschaltet ist, wobei ein Anschlußgebiet (3) wenigstens eines ersten im Halbleitersubstrat angeordneten Feldeffekttransistors (T1) mit einem Massepotential ($V_{SS}$) beaufschlagt ist und wobei das Halbleitersubstrat mit dem Ausgang (17) eines SubstratvorspannungsGenerators (16) verbunden ist, dem das Massepotential und die Versorgungsspannung zugeführt werden und der den pn-Übergang zwischen dem auf Massepotential liegenden Anschlußgebiet des ersten Feldeffekttransistors und dem Halbleitersubstrat in Sperrrichtung vorspannt, **gekennzeichnet durch** einen Komparator (24) mit zwei Eingängen, von denen der erste (25) mit dem Ausgang (17) des Substratvorspannungs-Generators (16) verbunden ist und der zweite (26) mit dem auf Massepotential liegenden Schaltungspunkt (8) in Verbindung steht, wobei der Ausgang (28) des Komparators an einen Steuereingang eines elektronischen Schalters (S1') geführt ist und wobei der Komparator (24) eine Schaltschwelle aufweist, die kleiner ist als die Durchlaßspannung des pn-Übergangs zwischen dem auf Massepotential liegenden Anschlußgebiet (3) des ersten Feldeffekttransistors (T1) und dem Halbleitersubstrat (1).

6. Integrierte Schaltung nach Anspruch 5, **durch gekennzeichnet,** daß der elektronische Schalter (S1') aus einem auf dem Halbleitersubstrat (1) angeordneten Feldeffekt-Schalttransistor besteht, dessen Anschlußgebiete jeweils dem zweiten Leitungstyp angehören und dessen Gate mit dem Ausgang des Komparators (28) verbunden ist.

7. Integrierte Schaltung nach einem der Ansprüche 5 oder 6, **dadurch gekennzeichnet,** daß der Komparator (24) eine erste Serienschaltung eines Lastelements (29) und eines ersten Feldeffekttransistors (T3) mit kleiner Einsatzspannung enthält, wobei diese Einsatzspannung kleiner ist als die Durchlaßspannung des pn-Übergangs zwischen dem auf Massepotential liegenden Anschlußgebiet (3) des ersten Feldeffekttransistors (T1) und dem Halbleitersubstrat (1), daß ein erster Anschluß (27) dieser Serienschaltung, der zugleich einen Anschluß des Lastelements darstellt, mit der Versorgungsspannung ($V_{DD}$) beschaltet ist, daß der zweite Anschluß dieser Serienschaltung, der zugleich einen Anschluß des ersten Feldeffekttransistors darstellt, den zweiten mit dem Massepotential ($V_{SS}$) belegten Eingang des Komparators bildet und daß ein Gateanschluß des ersten Feldeffekttransistors den ersten Eingang (25) des Komparators darstellt.

8. Integrierte Schaltung nach Anspruch 7, **dadurch gekennzeichnet,** daß das Lastelement (29) aus einem zweiten Feldeffekttransistor besteht, dessen Gate mit seinem Drainanschluß verbunden ist.

9. Integrierte Schaltung nach einem der Ansprüche 7 oder 8, **dadurch gekennzeichnet,** daß der Komparator (24) eine in Serie zu seinem Ausgang (28) liegende Verstärkerstufe (31) aufweist, die aus einer zweiten Serienschaltung eines dritten und eines vierten Feldeffekttransistors (T4, T5) besteht, die unterschiedlichen Kanaltypen angehören und deren Gates mit dem Verbindungspunkt (30) des ersten Feldeffekttransistors (T3) und des Lastelements (29) der ersten Serienschaltung verbunden sind, daß die zweite Serienschaltung einerseits über ein weiteres Lastelement (32) mit der Versorgungsspannung ($V_{DD}$) beschaltet ist und andererseits mit dem Ausgang (17) des Substratvorspannungs-Generators verbunden ist.

10. Integrierte Schaltung nach Anspruch 1, **durch** abgewandelt, daß das Halbleitersubstrat des ersten Leitungstyps (1) durch eine wannenförmige Halbleiterzone des ersten Leitungstyps ersetzt wird und daß die wannenförmige Halbleiterzone des zweiten Leitungstyps (2) durch ein Halbleitersubstrat des zweiten Leitungstyps ersetzt wird und daß die wannenförmige Halbleiterzone des ersten Leitungstyps in das Halbleitersubstrat des zweiten Leitungstyps eingefügt ist.

**11.** Integrierte Schaltung nach einem der vorhergehenden Ansprüche, **gekennzeichnet durch**
die Anwendung als Peripherieschaltung für dy-
namische Halbleiterspeicher hoher Integra-
tionsdichte.

## Claims

**1.** Integrated circuit based on complementary circuit design techniques, comprising field effect
transistors (T1, T2) of different channel types,
of which at least one first (T1) is arranged in a
doped semiconductor substrate (1) of a first
conductivity type and at least one second (T2)
is arranged in a tub-shaped semiconductor
zone (2) of a second conductivity type provided in the semiconductor substrate (1), the
semiconductor zone being connected to a supply voltage ($V_{DD}$), a connection region (3) first
field of at least one effect transistor (T1) arranged in the semiconductor substrate being
applied to an earth potential ($V_{SS}$) and the
semiconductor substrate being connected to
the output (17) of a substrate bias voltage
generator (16) to which the earth potential and
the supply voltage are fed and which biases
the p-n junction between the connection region, which is at earth potential, of the first
field effect transistor and the semiconductor
substrate in the reverse direction, characterised in that the output (17) of the substrate bias
voltage generator (16) is connected to a circuit
point (8), which is at earth potential, via an
electronic switch (S1), in that the electronic
switch is driven via the output (17) of the
substrate bias voltage generator (16), and in
that the turn-on voltage of the electronic switch
(S1) is less than the forward voltage of the p-n
junction between the connection region (3),
which is at earth potential, of the first field
effect transistor (T1) and the semiconductor
substrate (1).

**2.** Integrated circuit according to Claim 1, characterised in that the substrate bias voltage generator (16) is also integrated on the semiconductor substrate (1).

**3.** Integrated circuit according to Claim 1 or 2,
characterised in that the output (17) of the
substrate bias voltage generator (16) is connected to a first semiconductor region (20) of
the second conductivity type embedded in the
semiconductor substrate, in that a second
semiconductor region (21) of the second conductivity type is embedded in the semiconductor substrate, which second semiconductor region is connected to the circuit point (8) which
is at earth potential, in that a region of the
semiconductor substrate (1) lying between said
two semiconductor regions (20, 21) is covered
by a gate (22) separated from the boundary
surface (1a) of the semiconductor substrate by
a thin electrically insulating layer (23), which
gate forms, together with the two semiconductor regions, a field effect switching transistor
with a low turn-on voltage, and in that said field
effect switching transistor, whose gate (22) is
connected to the output (17) of the substrate
bias voltage generator (16), forms the electronic switch (S1).

**4.** Integrated circuit according to Claim 3, characterised in that the insulating layer (23) separating the gate (22) from the boundary surface
(1a) of the semiconductor substrate has a
thickness of about 15 nm.

**5.** Integrated circuit based on complementary circuit design techniques, incorporating field effect transistors (T1, T2) of different channel
types, of which at least one first (T1) is arranged in a doped semiconductor substrate (1)
of a first conductivity type and at least one
second (T2) is arranged in a tub-shaped semiconductor zone (2) of a second conductivity
type provided in the semiconductor substrate
(1), the semiconductor zone being connected
to a supply voltage ($V_{DD}$), a connection region
(3) of at least one first field effect transistor
(T1) arranged in the semiconductor substrate
being applied to an earth potential ($V_{SS}$) and
the semiconductor substrate being connected
to the output (17) of a substrate bias voltage
generator (16) to which the earth potential and
the supply voltage are fed and which biases
the p-n junction between the connection region, which is at earth potential, of the first
field effect transistor and the semiconductor
substrate in the reverse direction, characterised by a comparator (24) having two inputs, of
which the first (25) is connected to the output
(17) of the substrate bias voltage generator
(16) and the second (26) is in communication
with the circuit point (8) which is at earth
potential, the output (28) of the comparator
being fed to a control input of an electronic
switch (S1') and the comparator (24) having a
switching threshold which is less than the forward voltage of the p-n junction between the
connection region (3), which is at earth potential, of the first field effect transistor (T1) and
the semiconductor substrate (1).

6. Integrated circuit according to Claim 5, characterised in that the electronic switch (S1') comprises a field effect switching transistor which is arranged on the semiconductor substrate (1), each of whose connection regions belongs to the second conductivity type and whose gate is connected to the output of the comparator (28).

7. Integrated circuit according to either of Claims 5 or 6, characterised in that the comparator (24) contains a first series circuit of a load element (29) and of a first field effect transistor (T3) having a low turn-on voltage, said turn-on voltage being less than the forward voltage of the p-n junction between the connection region (3), which is at earth potential, of the first field effect transistor (T1) and the semiconductor substrate (1), in that a first connection (27) of said series circuit, which is at the same time a connection of the load element, is connected to the supply voltage (V_{DD}), in that the second connection of said series circuit, which is at the same time a connection of the first field effect transistor, forms the second input, applied to the earth potential (V_{SS}) of the comparator, and in that a gate connection of the first field effect transistor is the first input (25) of the comparator.

8. Integrated circuit according to Claim 7, characterised in that the load element (29) comprises a second field effect transistor whose gate is connected to its drain connection.

9. Integrated circuit according to either of Claims 7 or 8, characterised in that the comparator (24) has an amplifier stage (31) connected in series with its output (28), which amplifier stage comprises a second series circuit of a third and of a fourth field effect transistor (T4, T5) which belong to different channel types and whose gates are connected to the connection point (30) of the first field effect transistor (T3) and of the load element (29) of the first series circuit, and in that the second series circuit is connected, on the one hand, to the supply voltage (V_{DD}) via a further load element (32) and, on the other hand, to the output (17) of the substrate bias voltage generator.

10. Integrated circuit according to Claim 1, modified in that the semiconductor substrate of the first conductivity type (1) is replaced by a tub-shaped semiconductor zone of the first conductivity type, and in that the tub-shaped semiconductor zone of the second conductivity type (2) is replaced by a semiconductor substrate of the second conductivity type, and in that the tub-shaped semiconductor zone of the first conductivity type is embedded in the semiconductor substrate of the second conductivity type.

11. Integrated circuit according to any of the preceding claims, characterised by use as peripheral circuit for dynamic semiconductor memories of high integration density.

**Revendications**

1. Circuit intégré réalisé selon la technique des circuits complémentaires et comportant des transistors à effet de champ (T1,T2) possédant des types de canaux différents, et dont au moins l'un (T1) est disposé dans un substrat semiconducteur dopé (1) possédant un premier type de conductivité et dont au moins un second (T2) est disposé dans une zone semiconductrice (2) en forme de cuvette, prévue dans le substrat semiconducteur (1) et possédant un second type de conductivité, et dans lequel la zone semiconductrice est placée à une tension d'alimentation (V_{DD}), une région de raccordement (3) d'au moins un premier transistor à effet de champ (T1) disposé dans le substrat semiconducteur est chargée par un potentiel de masse (V_{SS}), et le substrat semiconducteur est raccordé à la sortie (17) d'un générateur (16) d'une tension de polarisation du substrat, auquel sont appliqués le potentiel de masse et la tension d'alimentation et qui polarise en inverse la jonction pn située entre la région de raccordement, placée au potentiel de masse, du premier transistor à effet de champ et le substrat semiconducteur, caractérisé par le fait que la sortie (17) du générateur (16) de la tension de polarisation du substrat est raccordée par l'intermédiaire d'un interrupteur électronique (S1) à un point (8) du circuit, placé au potentiel de masse, que l'interrupteur électronique est commandé par l'intermédiaire de la sortie (17) du générateur (16) de la tension de polarisation du substrat et que la tension de déclenchement de l'interrupteur électronique (S1) est inférieure à la tension de claquage de la jonction pn située entre la région de raccordement (3), placée au potentiel de masse, du premier transistor à effet de champ (T1) et le substrat semiconducteur (1).

2. Circuit intégré suivant la revendication 1, caractérisé par le fait que le générateur (16) de la tension de polarisation du substrat est intégré dans le substrat semiconducteur (1).

3. Circuit intégré selon la revendication 1 ou 2, caractérisé par le fait que la sortie (17) du générateur (16) de la tension de polarisation du substrat est raccordée à une première région semiconductrice (20) qui est insérée dans le substrat semiconducteur et possède le second type de conductivité, que dans le substrat semiconducteur est insérée une seconde région semiconductrice (21) possédant le second type de conductivité et qui est raccordé au point (8) du circuit, placé au potentiel de masse, qu'une région du substrat semiconducteur (1), située entre ces deux régions semiconductrice (20,21), est recouverte par une grille (22) séparée de la face limite (1a) du substrat semiconducteur par une mince couche électriquement isolante (23), et qui forme, avec les deux régions semiconductrices, un transistor à effet de champ possédant une faible tension de déclenchement, et que ce transistor à effet de champ, dont la grille (22) est raccordée à la sortie (17) du générateur (16) de la tension de polarisation du substrat, forme l'interrupteur électronique (S1).

4. Circuit intégré suivant la revendication 3, caractérisé par le fait que la couche isolante (23), qui sépare la grille (22) de la surface limite (1a) du substrat semiconducteur, possède une épaisseur égale à environ 15 nm.

5. Circuit intégré réalisé selon la technique des circuits complémentaires et comportant des transistors à effet de champ (T1,T2) possédant des types de canaux différents, et dont au moins l'un (T1) est disposé dans un substrat semiconducteur dopé (1) possédant un premier type de conductivité et dont au moins un second (T2) est disposé dans une zone semiconductrice (2) en forme de cuvette, prévue dans le substrat semiconducteur (1) et possédant un second type de conductivité, et dans lequel la zone semiconductrice est placée à une tension d'alimentation ($V_{DD}$), une région de raccordement (3) d'au moins un premier transistor à effet de champ (T1) disposé dans le substrat semiconducteur est chargée par un potentiel de masse ($V_{SS}$), et le substrat semiconducteur est raccordé à la sortie (17) d'un générateur (16) d'une tension de polarisation du substrat, auquel sont appliqués le potentiel de masse et la tension d'alimentation et qui polarise en inverse la jonction pn située entre la région de raccordement, placée au potentiel de masse, du premier transistor à effet de champ et le substrat semiconducteur, caractérisé par un comparateur (24) comportant deux entrées, dont la première (25) est raccordée à la sortie (17) du générateur (16) de la tension de polarisation du substrat et dont la seconde (26) est raccordée au point (8) du circuit, placé au potentiel de masse, la sortie (28) du comparateur étant raccordée à une entrée de commande d'un interrupteur électronique (S1'), tandis que le comparateur (24) possède un seuil de commutation inférieur à la tension de claquage de la jonction pn présente entre la région de raccordement (3), placée au potentiel de masse, du premier transistor à effet de champ (T1) et le substrat semiconducteur (1).

6. Circuit intégré suivant la revendication 5, caractérisé par le fait que l'interrupteur électronique (S1') est constitué par un transistor à effet de champ disposé sur le substrat semiconducteur (1) dont les régions de raccordement possèdent respectivement le second type de conductivité et dont la grille est raccordée à la sortie du comparateur (28).

7. Circuit intégré suivant les revendications 5 ou 6, caractérisé par le fait que le comparateur (24) contient un premier circuit série formé d'un élément de charge (29) et d'un premier transistor à effet de champ (T3) possédant une faible tension de déclenchement, qui est inférieur à la tension de claquage de la jonction pn de la région de raccordement (3), située au potentiel de masse, du premier transistor à effet de champ (T1), et le substrat semiconducteur (1), qu'une première borne (27) de ce circuit série, qui représente simultanément une borne de l'élément de charge, est raccordée à la tension d'alimentation ($V_{DD}$), que la seconde borne de ce circuit série, qui représente simultanément une borne du premier transistor à effet de champ, constitue la seconde entrée du comparateur, qui est placée au potentiel de masse ($V_{SS}$) et qu'une borne de grille du premier transistor à effet de champ représente la première entrée (25) du comparateur.

8. Circuit intégré suivant la revendication 7, caractérisé par le fait que l'élément de charge (29) est constitué par un second transistor à effet de champ, dont la grille est raccordée à sa borne de drain.

9. Circuit intégré suivant l'une des revendications 7 ou 8, caractérisé par le fait que le comparateur (24) possède un étage amplificateur (31), qui est branché en série avec sa sortie (28) et est constitué par un second montage série formé de troisième et quatrième transistors à effet de champ (T4,T5), qui possèdent des types de canaux différents et dont les grilles sont raccordées au point de jonction (30) du premier transistor à effet de champ (T3) et de l'élément de charge (29) du premier circuit série, que le second circuit série est raccordé pour sa part par l'intermédiaire d'un autre élément de charge (32) à la tension d'alimentation ($V_{DD}$) et d'autre part, à la sortie (17) du générateur de la tension de polarisation du substrat.

10. Circuit intégré suivant la revendication 6, caractérisé par le fait que le substrat semiconducteur possédant le premier type de conductivité (1) est remplacé par une zone semiconductrice en forme de cuvette, possédant le premier type de conductivité, et que la zone semiconductrice en forme de cuvette possédant le second type de conductivité (2) est remplacée par un substrat semiconducteur possédant le second type de conductivité, et que la zone semiconductrice en forme de cuvette possédant le premier type de conductivité est insérée dans le substrat semiconducteur possédant le second type de conductivité.

11. Circuit intégré suivant l'une des revendications précédentes, caractérisé par l'utilisation, comme circuit périphérique, de mémoires dynamiques à semiconducteurs possédant une haute densité d'intégration.

FIG 1

FIG 2

# FIG 3